# EUROPEAN PATENT APPLICATION

(11) **EP 2 903 165 A1**
(43) Date of publication of application: **05.08.2015**
(21) Application number: 14305148.0
(22) Date of filing: 04.02.2014
(51) Int. Cl.: H03M 1/08, H03M 1/36

(54) **Method For Converting An Analogue Signal Into A Digital Signal, Analogue-To-Digital Converter System, Receiver Apparatus And Network Node Thereof**

(71) Applicant: ALCATEL LUCENT, 92100 Boulogne-Billancourt (FR)
(72) Inventor: Yu, Xin, 70435 Stuttgart (DE); Markert, Daniel, 70435 Stuttgart (DE); Bohn, Thomas, 70435 Stuttgart (DE)
(74) Representative: 2SPL Patentanwälte PartG mbB

(57) **Abstract**

The embodiments of the invention relate to a method for converting an analogue signal (ANG-S) into a digital signal (DIG-S). The method contains the steps of extracting at an input of an analogue-to-digital converter system (ADC-SYS-1) at least one interference signal (IS) from the analogue signal (ANG-S), which contains a wanted signal (WS) and the at least one interference signal (IS). The method further contains the step of generating from the at least one interference signal (IS) a variable offset voltage signal (V-OFFSET). The method further contains determining at least one dynamical reference voltage (DYN-REF-V-1, DYN-REF-V-2, DYN-REF-V-1 a) based on the variable offset voltage signal (V-OFFSET). The method further contains applying the at least one dynamical reference voltage (DYN-REF-V-1, DYN-REF-V-2, DYN-REF-V-1a) to at least one reference voltage input (REFV-IN-1, REFV-IN-2, REFV-IN-1a) of an analogue-to-digital converter module (ADC-M-1, ADC-M-2) and further applying the analogue signal (V-ANG-S) to a signal input (ANGS-IN-a, ANGS-IN-b) of the analogue-to-digital converter module (ADC-M-1, ADC-M-2). The method even further contains converting the analogue signal (V-ANG-S) to the digital signal (DIG-S) based on the at least one dynamical reference voltage (DYN-REF-V-1, DYN-REF-V-2, DYN-REF-V-1a). The embodiments further relate to an analogue-to-digital converter system (ADC-SYS-1, ADC-SYS-2), to a receiver apparatus which contains the analogue-to-digital converter system and to a network node which contains the receiver apparatus.

## Description

### FIELD OF THE INVENTION

The present invention relates to conversion of an analogue signal into a digital signal and, more particularly but not exclusively, to analogue-to-digital conversion in a receiver for radio frequency signals.

### BACKGROUND

This section introduces aspects that may be helpful in facilitating a better understanding of the invention. Accordingly, the statements of this section are to be read in this light and are not to be understood as admission about what is in the prior art.

An ADC (ADC = Analogue-to-Digital Converter) is a critical component in receivers such as radio receivers with respect to signal processing of a signal which has been received by the receiver. Such a received signal usually not only contains a wanted signal but also one or several interference signals which have been also received by the receiver. The interference signals which may be also called blocker signals can be quite large and can reach or exceed a so-called full scale limit of the ADC. In such a case the ADC will be blocked and an output signal of the ADC contains only information of the interference signal and no information of the wanted signal. Thereby, an output signal of the ADC is totally corrupted and does neither reflect the blocker signals nor the wanted signal. But also in cases where the interference signal does not hit the full scale limit of the ADC, the interference signal is still able to degenerate a performance of the ADC which results in a low SNR value of the wanted signal (SNR = Signal to Noise Ratio), a low so-called power ratio to ADC quantization noise and a high BER (BER = Bit Error Rate).

Interference signals which are located within a system band or transmission band cannot be filtered out by a band pass antenna filter. Also digital solutions cannot overcome this problem, because the ADC is located at a beginning of a digital processing chain and when the ADC is already overdriven no improvement of the signal quality can be obtained in the further digital processing chain.

One possible solution to overcome this problem is increasing a resolution and thereby a sensitivity of the ADC to alleviate the impact of the interference signals. However, on the one hand ADCs with high resolution are expensive and on the other hand it is not possible to arbitrarily increase the ADC resolution.

Another solution proposes to cancel out the interference signals directly at an LNA (LNA = Low Noise Amplifier) of the receiver by using a so-called integrated bandpass feedback stage. A narrow band blocker signal would be amplified and extracted by filtering, and then fed to an input port of the LNA with a 180 degree phase shift. Furthermore, a complex hardware circuitry is needed. Only narrow band distortion and interference signals coming from a receiving antenna can be suppressed and cancelled out. This means, that distortions coming from sources of interference within same equipment (e. g. crosstalk from a transmitter, reference frequencies, DSP frequencies, spurious signal) cannot be suppressed by the LNA and therefore may be still be part of the digitized signal and degrade a quality of the digitized signal.

### SUMMARY

Thus, an object of the embodiments of the invention is to provide a cost effective solution for a receiver which also reduces distortions coming from sources of interference which are part of the receiver.

The object is achieved by a method for converting an analogue signal into a digital signal. The method contains the step of extracting at an input of an analogue-to-digital converter system at least one interference signal from the analogue signal, which contains a wanted signal and the at least one interference signal. The method further contains the steps of generating from the at least one interference signal a variable offset voltage and determining at least one dynamical reference voltage based on the variable offset voltage. The method even further contains the step of applying the at least one dynamical reference voltage to at least one reference voltage input of an analogue-to-digital converter module and further applying the analogue signal to a signal input of the analogue-to-digital converter module. The method also further contains the step of converting the analogue signal to the digital signal based on the at least one dynamical reference voltage.

The object is further achieved by an analogue-to-digital converter system for converting an analogue signal into a digital signal. The analogue-to-digital converter system contains means for extracting at an input of the analogue-to-digital converter system at least one interference signal from the analogue signal which contains a wanted signal and the at least one interference signal. The analogue-to-digital converter system further contains means for generating from the at least one interference signal a variable offset voltage and means for determining at least one dynamical reference voltage based on the variable offset voltage. The analogue-to-digital converter system even further contains means for applying the at least one dynamical reference voltage to at least one reference voltage input of an analogue-to-digital converter module and means for applying the analogue signal to a signal input of the analogue-to-digital converter module. The analogue-to-digital converter system also contains means for converting the analogue signal into the digital signal based on the at least one dynamical reference voltage.

The analogue-to-digital converter system may be based for example on a Flash analogue-to-digital converter, an analogue-to-digital converter with pulse-width modulation or an analogue-to-digital converter with delta-sigma modulation.

In embodiments, the means for extracting the at least one interference signal may correspond to any extraction unit, extracting module, a combination of a directional coupler and a filter unit such as a band-stop filter or a band pass filter. A selection of a concrete type may depend on a concrete application such as band-pass filter for extracting the at least one interference signal, if it is narrow band as well as its frequency location is known and kept unchanged during operation. A band stop filter for suppressing the wanted signal might be appropriate for the case, where the interference signal is broad band and its frequency location is unknown. Hence, in embodiments the means for extracting the at least one interference signal may contain an input for the analogue signal, a partitioning unit such as the directional coupler which splits the analogue signal into a first part and a second part and a separation unit such as the filter unit which lets pass only the at least one interference signal, and an output for the at least one interference signal. In some embodiments the means for extracting the at least one interference signal can be implemented at least partly in terms of a computer program and a hardware component on which the computer program is executed, such as a DSP (DSP = Digital Signal Processor), an ASIC (ASIC = Application-Specific Integrated Circuit), an FPGA (FPGA = Field-Programmable Gate Array) or any other processing unit.

In embodiments, the means for generating the variable offset voltage may correspond to any voltage generation unit, power detector, power meter etc. Hence, in embodiments the means for generating the variable offset voltage may contain an input for the at least one interference signal, an electrical circuitry which transforms the at least one interference signal into the variable offset voltage, and an output for the variable offset voltage. In some embodiments the means for determining the first initial beam parameters and the second initial beam parameters can be implemented in terms of a computer program and a hardware component on which the computer program is executed, such as a DSP, an ASIC, an FPGA or any other processing unit.

In embodiments, the means for determining the at least one dynamical reference voltage may correspond to any determining unit, adding unit, adding module, voltage adder etc. Hence, in embodiments the means for determining the at least one dynamical reference voltage may contain inputs for the variable offset voltage and at least one reference voltage, an electrical circuitry which adds the variable offset voltage and the at least one reference voltage, and an output for the at least one dynamical reference voltage. In some embodiments the means for determining the at least one dynamical reference voltage can be implemented in terms of a computer program and a hardware component on which the computer program is executed, such as a DSP, an ASIC, an FPGA or any other processing unit.

In embodiments, the means for applying the at least one dynamical reference voltage to the at least one reference voltage input and the means for applying the analogue signal to the signal input may correspond to an electrical summation, for example by a combination of connection/branch lines and input pins/ports etc. Hence, in embodiments the means for applying the at least one dynamical reference voltage to the at least one reference voltage input and the means for applying the analogue signal to the signal input may contain in each case for example a connection line which is connected to an input port of the analogue-to-digital converter module. In some embodiments the means for applying the at least one dynamical reference voltage to the at least one reference voltage input and the means for applying the analogue signal to the signal input can be implemented in terms of a computer program and a hardware component on which the computer program is executed, such as a DSP, an ASIC, an FPGA or any other processing unit.

In embodiments, the means for converting the analogue signal into the digital signal may correspond to any converting unit, comparator, converting module, ADC chip, ADC integrated circuit etc. Hence, in embodiments the means for converting the analogue signal into the digital signal t may contain an input for the analogue signal and at least one input for the at least one dynamical reference voltage, an electrical circuitry which converts the analogue signal into the digital signal, and an output for the digital signal. In some embodiments the means for converting the analogue signal into the digital signal can be implemented in terms of a computer program and a hardware component on which the computer program is executed, such as a DSP, an ASIC, an FPGA or any other processing unit.

The object is even further achieved by a receiver apparatus which contains the analogue-to-digital converter system and by a network node which contains the receiver apparatus.

The receiver apparatus may be for example a receiver apparatus for radio frequency signals and the may be for example a base station, a relay station or a mobile station.

The embodiments provide a novel ADC concept which is based on a dynamical offset voltage or dynamical offset signal. The dynamical offset voltage/signal can easily be added to a common reference voltage or reference signal without a requirement of further modification of common ADC designs. Such a concept can significantly reduce an impact of low-frequency interference signals on the ADC resolution. The embodiments provide a main advantage of proposing a simple and straightforward cancellation concept to increase a power ratio of the wanted signal to ADC quantization noise with coexistence of one or several high interference signals. Thereby, the ADC resolution is not wasted for the interference signals and primarily the wanted signal of the analogue signal is converted to the digital signal. The embodiments provide a further advantage of suppressing distortions coming from sources of interference within the receiver apparatus.

Further advantageous features of the embodiments of the invention are defined in the dependent claims and are described in the following detailed description.

### BRIEF DESCRIPTION OF THE FIGURES

The embodiments of the invention will become apparent in the following detailed description and will be illustrated by accompanying figures given by way of non-limiting illustrations.
Figure 1 shows exemplarily a characteristic curve of an analogue signal which is a superposition of a sinus interference signal and a wanted LTE signal (LTE = Long Term Evolution).
Figure 2 shows schematically a basic flow diagram of a method for converting an analogue signal into a digital signal according to an exemplary embodiment.
Figure 3 shows schematically a block diagram of an analogue-to-digital converter system for converting an analogue signal into a digital signal according to a first exemplary embodiment.
Figure 4 shows characteristic curves of a magnitude of a band stop filter and of a phase of the band stop filter according to an exemplary embodiment.
Figure 5 shows schematically a flow diagram of a method for converting the analogue signal into the digital signal according to the first exemplary embodiment.
Figure 6 shows schematically a block diagram of an analogue-to-digital converter system for converting an analogue signal into a digital signal according to a second exemplary embodiment.
Figure 7 shows schematically a flow diagram of a method for converting the analogue signal into the digital signal according to the second exemplary embodiment.
Figure 8a shows exemplarily a characteristic curve for a spectral power characteristic of an LTE signal without an application of a dynamical reference voltage and Figure 8b shows exemplarily a further characteristic curve with a spectral power characteristic of the LTE signal when the dynamical reference voltage is applied.
Figure 9a shows exemplarily a characteristic curve for a spectral power characteristic of a GSM signal as an interference signal and an LTE signal as a wanted signal without an application of a dynamical reference voltage and Figure 9b shows exemplarily a further characteristic curve when the dynamical reference voltage is applied.
Figure 10 shows schematically a block diagram of a receiver apparatus which contains an analogue-to-digital converter system for converting an analogue signal into a digital signal according to an exemplary embodiment.
Figure 11 shows schematically a block diagram of a network node which contains a receiver apparatus with an analogue-to-digital converter system for converting an analogue signal into a digital signal according to an exemplary embodiment.

### DESCRIPTION OF THE EMBODIMENTS

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

A splitting of processing functions across processing units shown in the Figures is not critical, and as can be understood by those skilled in the art that the number of processing units, the number of processing functions and an allocation of the processing functions to the processing units may vary without departing from the scope of the embodiments of the invention as defined in the appended claims. The number of the steps for performing the method(s) is not critical, and as can be understood by those skilled in the art that the number of the steps and the sequence of the steps may vary without departing from the scope of the embodiments of the invention as defined in the appended claims.

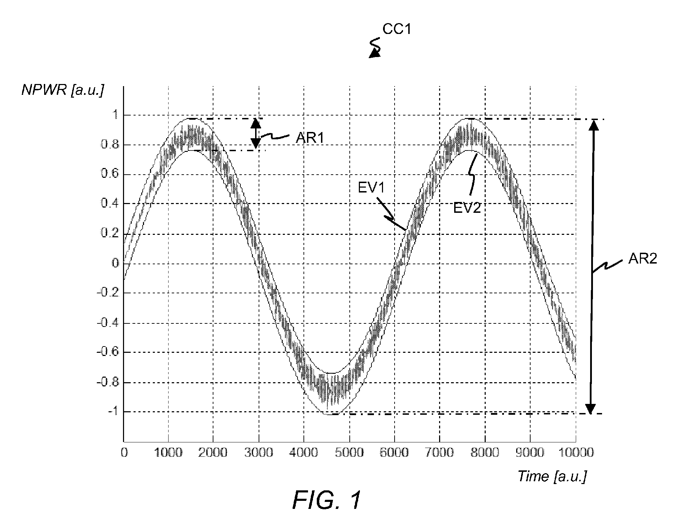

Figure 1 shows exemplarily a characteristic curve CC1 of an analogue signal as a function of time in arbitrary units. The characteristic curve CC1 is a superposition of a sinusoidal interference signal and a wanted signal (here an LTE signal). A curve EV1 and a further curve EV2 are used to indicate an amplitude range AR1 of the wanted signal, which is much smaller than an amplitude range AR2 of the entire signal, which includes the wanted signal and the sinusoidal interference signal. The interference signal and wanted signal cannot be directly observed in Figure 1.

When such an analogue signal is applied to a conventional ADC, which is usually only adapted and optimized for a sufficient resolution of the amplitude range AR1 of the wanted signal, the conventional ADC will be overloaded to a large extend by the amplitude range AR1 of the entire signal.

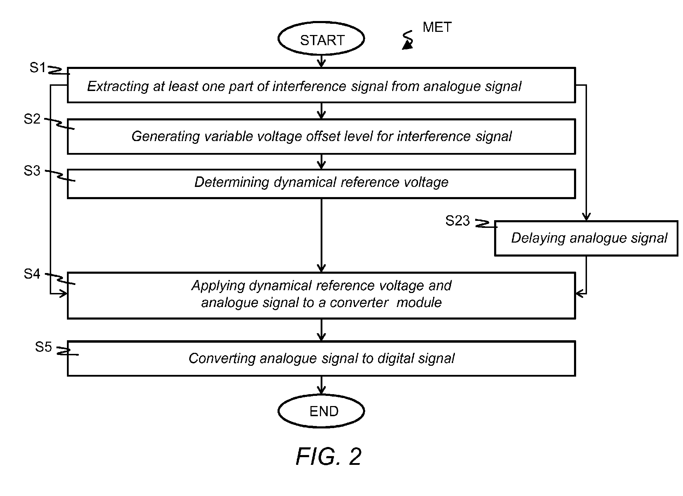

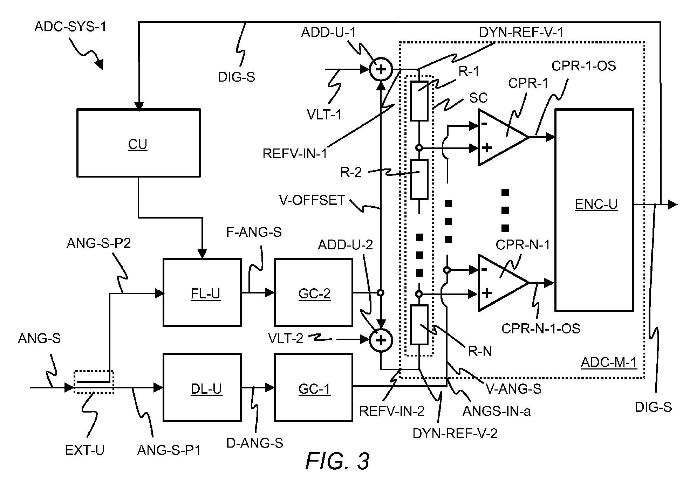

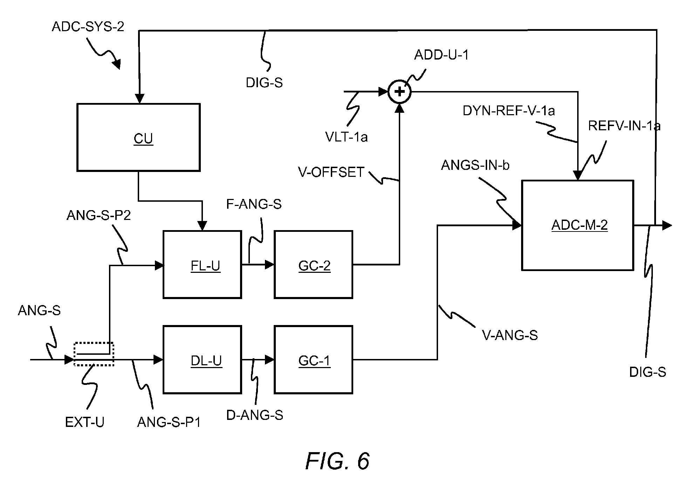

Figure 2 shows schematically a flow diagram of a basic method MET for converting the analogue signal which is exemplarily shown in Figure 1 into a digital signal. The method TRA-MET describes basic processing steps of analogue-to-digital converter systems which are shown in Figure 3 and Figure 6.

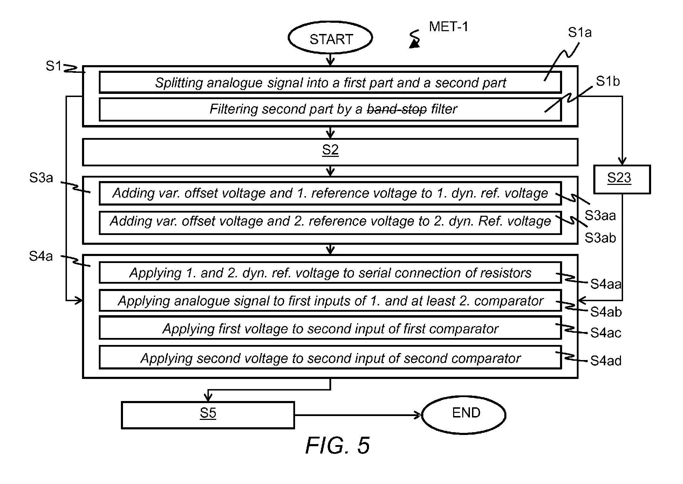

When the analogue signal ANG-S which contains at least one interference signal IS and the wanted signal WS enters an analogue-to-digital converter system ADC-SYS-1 as shown for example in Figure 1, in a first step S1 the analogue signal ANG-S is processed at an input of the analogue-to-digital converter system ADC-SYS-1 in such a way, that the at least one interference signal IS is extracted from the analogue signal ANG-S. More details regarding the extraction are described with respect to Figure 5.

In a next step S2, a variable offset voltage signal V-OFFSET is generated based on the at least one interference signal IS. The variable offset voltage signal V-OFFSET may be for example generated or manipulated by an electrical circuitry such as a gain controller which converts the at least one interference signal IS into the variable offset voltage signal V-OFFSET. A value of the variable offset voltage signal V-OFFSET may be regulated in such a way that a power level matching for a better cancellation effect is achieved.

By a further step S3, at least one dynamical reference voltage DYN-REF-V-1, DYN-REF-V-2 is determined based on the variable offset voltage signal V-OFFSET and based on at least one reference voltage VLT-1, VLT-2. More details regarding the determination of the at least one dynamical reference voltage DYN-REF-V-1, DYN-REF-V-2 are described with respect to Figure 5.

In a next step S4, the at least one dynamical reference voltage DYN-REF-V-1, DYN-REF-V-2 is applied to at least one reference voltage input REFV-IN-1, REFV-IN-2 of an analogue-to-digital converter module ADC-M-1 and a characteristic parameter of the analogue signal ANG-S is applied to a signal input ANGS-IN-a of the analogue-to-digital converter module ADC-M-1. The characteristic parameter of the analogue signal ANG-S is for example a voltage signal V-ANG-S being generated based on a first part ANG-S-P1 of the analogue signal ANG-S and which corresponds to a current voltage level of the analogue signal ANG-S.

A time offset between the voltage signal V-ANG-S being generated based on the analogue signal ANG-S and the at least one dynamical reference voltage DYN-REF-V-1, DYN-REF-V-2 which are both based on same time instances of the analogue signal ANG-S can significantly deteriorate the cancellation performance. Therefore, by an optional step S23 the analogue signal is delayed for compensating a time delay, when steps S1, S2 and S3 take too much time, when the time offset exceeds for example a predefined time offset of 20 ns. The time delay is adapted or equal to the time offset. For minimal time delays (i.e. below 20 ns) the delaying step can be obmitted, e.g. when the generation of the dynamical reference voltage is fast enough.

Preferably, the time offset is given by a time difference between the voltage signal V-ANG-S being based on the first part ANG-S-P1 of the analogue signal ANG-S and the at least one dynamical reference voltage DYN-REF-V-1, DYN-REF-V-2 being based on a second part ANG-S-P2 of the analogue signal ANG-S.

In a final step S5, the analogue signal such as the voltage signal V-ANG-S is converted into a digital signal DIG-S based on the at least one dynamical reference voltage DYN-REF-V-1, DYN-REF-V-2.

Figure 3 shows schematically a block diagram of the analogue-to-digital converter system ADC-SYS-1 for converting the analogue signal ANG-S into the digital signal DIG-S. The analogue signal ANG-S may be for example a down-converted intermediate frequency signal or a radio frequency signal which has been received by an antenna system and which has been fed to the analogue-to-digital converter system ADC-SYS-1 by a fixed line such as printed circuit. Regarding the second alternative, a down-conversion may be done using an output signal of the analogue-to-digital converter system ADC-SYS-1.

The exemplarily shown analogue-to-digital converter system ADC-SYS-1 contains an extracting unit EXT-U, a delaying unit DL-U, a first gain control unit GC-1, a filter unit FL-U, a second power detector unit power control unit GC-2, a first adding unit ADD-U-1, a second adding unit ADD-U-2 and an analogue-to-digital converter module ADC-M-1 (see dotted plotted large rectangle).

The analogue signal ANG-S which has preferably an IF (IF = Intermediate Frequency) is applied at an input of the analogue-to-digital converter system ADC-SYS-1 to the extracting unit EXT-U. The extracting unit EXT-U may be for example a directional coupler or a splitter, e. g. a Wilkinson splitter. The extracting unit EXT-U is adapted to split the analogue signal ANG-S into the first part ANG-S-P1 and the second part ANG-S-P2 and to output the first part ANG-S-P1 to a first processing sub-chain and the second part ANG-S-P2 to a second processing sub-chain. Preferably, the extracting unit EXT-U splits the analogue signal ANG-S by a predefined power level ratio preferably with a splitting ratio of 1:1. Since processed signals are combined with matched power levels, the splitting ration of 1:1 may lead to best performance results. between a power level of the first part ANG-S-P1 and a power level of the second part ANG-S-P2. In further embodiments, a predefined power level ratio close to 1:1 may be applied for obtaining a best performance. But because of the application of the gain control units GC-1, GC-2 the splitting ratio is not critical.

The first processing sub-chain contains the delaying unit DL-U and the first gain control unit GC-1 and the second processing sub-chain contains the filter unit FL-U, the second gain control unit GC-2, the first adding unit ADD-U-1 and the second adding unit ADD-U-2.

The first part ANG-S-P1 of the analogue signal ANG-S is provided to an input port of the delaying unit DL-U. The delaying unit DL-U is for example a delay line such as a printed circuit board track of a predefined length or a discrete phase shifter. The delaying unit DL-U delays the first part ANG-S-P1 according to the time difference which exists between processing the first part ANG-S-P1 by the first processing sub-chain and processing the second part ANG-S-P2 by the second processing sub-chain. The delaying unit DL-U outputs a delayed analogue signal D-ANG-S which is provided to a measurement connection of the first gain control unit GC-1. The first gain control unit GC-1 is for example a tunable attenuator. The first gain control unit GC-1 converts the delayed analogue signal D-ANG-S by a corresponding electrical circuitry into the voltage signal V-ANG-S and outputs the voltage signal V-ANG-S at a signal output port of the first gain control unit GC-1.

The second part ANG-S-P2 of the analogue signal ANG-S is provided to an input port of the filtering unit FL-U. The filtering unit FL-U is preferably a so-called band-stop filter which is the opposite of a so-called band-pass filter. The band-stop filter has preferably an order of 6 or an order below 6 or above 6 depending on system requirements. The higher the order of the band-stop filter, the better the separation of interference signals and the wanted signal, the better the suppression of the wanted signal and the higher the SNR after analogue to digital conversion. The intention of the band stop filter is to attenuate the wanted signal in the second part ANG-S-P2 of the analogue signal ANG-S and to extract or output the interference signals. A band stop filter may be applied, if frequency positions of the interference signals are unknown.

Ideally, only a voltage level difference between the variable offset voltage signal V-OFFSET and the voltage signal V-ANG-S may be digitalized.

The variable offset voltage signal V-OFFSET contains only the interference signal and the attenuated wanted signal. The first part ANG-S-P1 is the superposition of the interference signal and the wanted signal. The analogue-to-digital converter module ADC-M-1 is used for executing the subtraction between the variable offset voltage signal V-OFFSET and the first part ANG-S-P1. Ideally, the difference between the variable offset voltage signal V-OFFSET and the first part ANG-S-P1 is the wanted signal.

The filter unit FL-U of the analogue-to-digital converter system ADC-SYS-1 may be a discrete device and further components of the analogue-to-digital converter system ADC-SYS-1 are integrated in a same processing chip.

The analogue-to-digital converter system ADC-SYS-1 allows to filter out interference signals, which's frequency shall not overlap with the frequency of wanted signal. A minimum difference between these frequencies depends on the characteristics of the bandstop filter and system requirements.

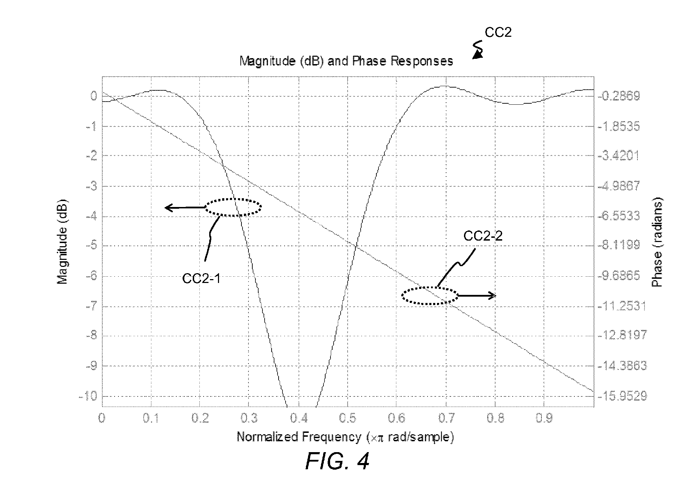

The analogue-to-digital converter system ADC-SYS-1 further contains a control unit CU for controlling the filter unit FL-U such as a tunable band-pass filter by shifting the tunable band-pass filter. More details are given below with respect to the description of Figure 4.

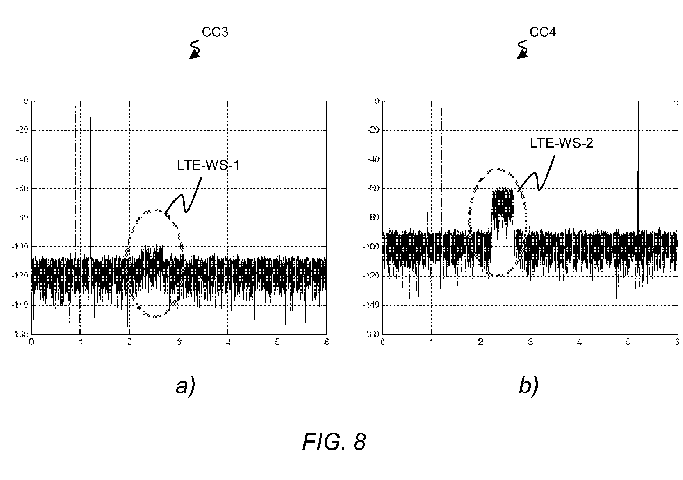

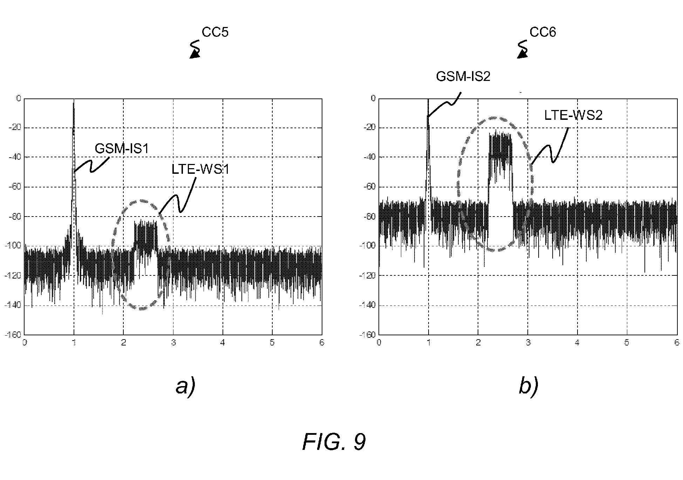

Figure 4 shows in a diagram CC2 a first characteristic curve CC2-1 of a magnitude of a band stop filter of order 6 and a second characteristic curve CC2-2 of a phase of the band stop filter according to an exemplary embodiment. Already for such a band stop filter an improvement of more than 10 dB can be achieved for a power ratio between the wanted signal WS and a so-called quantization noise floor (see also Figures 8 and 9). This result has been determined in simulations for a first case without an application of the at least one dynamical reference voltage DYN-REF-V-1, DYN-REF-V-2 and for a second case with an application of the at least one dynamical reference voltage DYN-REF-V-1, DYN-REF-V-2.

The filtering unit FL-U filters the second part ANG-S-P2 in such a way that spectral components of the wanted signal WS are blocked or attenuated to a large extend (preferably completely eliminated) and that preferably only spectral components of the one or several interference signals pass the filtering unit FL-U almost unchanged with a same power level and delay as at the input port of the filtering unit FL-U.

In a further embodiment, the filtering unit FL-U may be designed as a narrow band-pass filter and adapted to block or suppress almost all spectral components of the second part ANG-S-P2 except for a spectral component which contains an interference signal with a dominating maximum power level which is provided to an output port of the filtering unit FL-U almost unchanged without attenuation of the maximum power level. The filtering unit FL-U outputs a filtered analogue signal F-ANG-S which is provided to a measurement connection of the gain control unit GC-2. The second gain control unit GC-2 is for example an attenuator. The second gain control unit GC-2 modifies the filtered analogue signal F-ANG-S by a corresponding electrical circuitry into the variable offset voltage signal V-OFFSET and outputs the offset voltage signal V-OFFSET at a signal output port of the second power detector unit PDW-U-2. The offset voltage signal V-OFFSET preferably is only based on or related to the interference signal IS and not based on or not related to the wanted signal WS.

A frequency location of the spectral component which contains the interference signal with the dominating maximum power level may change from time to time. For automatically adjusting the filtering characteristic of the band-pass filter to this spectral component, the band-pass filter may be a tunable band-pass filter. The frequency location may be estimated for example by the control unit CU (see Figure 3). The digital signal DIG-S would be at first fed to the control unit CU. Subsequently, by using FFT (FFT = Fast Fourier Transformation) the frequency position of the interference signal is determined and then the control unit CU controls the filter unit FL-U such as a tunable band-pass filter by shifting the tunable band-pass filter accordingly. However, when the analogue-to-digital converter module ADC-M-1 is overdriven, a frequency position of the largest interference signal can still be observed or determined after FFT.

The offset voltage signal V-OFFSET is applied to a first input port of the first adding unit ADD-U-1 and to a second input port of the second adding unit ADD-U-2. The first adding unit ADD-U-1 and the second adding unit ADD-U-2 are for example combiners. A first reference voltage VLT-1 with a first preferably constant voltage level of for example 2 volt may be applied to a second input port of the first adding unit ADD-U-1 and a second reference voltage VLT-2 with a second preferably constant voltage level of for example -2 volt may be applied to a second input port of the second adding unit ADD-U-2. The first adding unit ADD-U-1 adds the first reference voltage VLT-1 and the offset voltage signal V-OFFSET for obtaining and outputting a first sum voltage which is a first dynamical reference voltage DYN-REF-V-1. Equally, the second adding unit ADD-U-2 adds the second reference voltage VLT-2 and the offset voltage signal V-OFFSET for obtaining and outputting a second sum voltage which is a second dynamical reference voltage DYN-REF-V-2.

The first dynamical reference voltage DYN-REF-V-1 is provided to a first reference voltage input REFV-IN-1 of the analogue-to-digital converter module ADC-M-1 and the second dynamical reference voltage DYN-REF-V-2 is provided to a second reference voltage input REFV-IN-2 of the analogue-to-digital converter module ADC-M-1. The voltage signal V-ANG-S which corresponds to the analogue signal ANG-S is applied to a signal input ANGS-IN-a of the analogue-to-digital converter module ADC-M-1.

The analogue-to-digital converter module ADC-M-1 which is sketched in Figure 3 is a conventional so-called Flash ADC and contains a serial connection SC of a number of N resistors R-1, R-2, ..., R-N, a number/group of N-1 comparators CPR-1, ..., CPR-N-1 and an encoding unit ENC-U. The number of N resistors is for example 5, 9, 12, 14 or 16, depending on the ADC resolution.

The first reference voltage input REFV-IN-1 of the analogue-to-digital converter module ADC-M-1 is connected to a first end of the serial connection SC and the second reference voltage input REFV-IN-2 of the analogue-to-digital converter module ADC-M-1 is connected to an opposite second end of the serial connection SC. Thereby, the first dynamical reference voltage DYN-REF-V-1 is applied to the first end of the serial connection SC and the second dynamical voltage is applied to the second opposite end of the serial connection SC.

The signal input ANGS-IN-a of the analogue-to-digital converter module ADC-M-1 is connected to first inputs (here to so-called non-inverting inputs V+) of the comparators CPR-1, ..., CPR-N-1. Thereby, the voltage V-ANG-S is applied to the first inputs of the comparators CPR-1, ..., CPR-N-1. To each electrical connection between two of the resistors of the serial connection SC a further electrical connection is connected with one end as a so-called resistor tap and an opposite the further electrical connection is connected to second inputs (here to so-called inverting inputs V-) of the comparators CPR-1, ..., CPR-N-1. Thereby a first voltage level between the first dynamical reference voltage DYN-REF-V-1 and the second dynamical reference voltage DYN-REF-V-2 is applied to a second input of a first one of the comparators (CPR-1, ..., CPR-N-1) and at least a second voltage between the first dynamical reference voltage level DYN-REF-V-1 and the second dynamical reference voltage DYN-REF-V-2 and different to the first voltage level is applied to a second input of at least a second one of the comparators CPR-1, ..., CPR-N-1. The comparators CPR-1, ..., CPR-N-1 generate a logical '0' or '1' depending if the measured voltage is above or below the reference voltage of the resistor tap. Output signals CPR-1-OS, ..., CPR-N-1-OS of the comparators CPR-1, ..., CPR-N-1 are provided to inputs of the encoding unit ENC-U. The encoding unit ENC-U may contain for example an amplification stage, a so-called bubble error correction and a digital encoding. Bubble error correction is a digital correction mechanism that will prevent a comparator that has, for example, tripped high from reporting logic high if it is surrounded by comparators that are reporting logic low. An output port of the encoding unit ENC-U finally provides and outputs the digital signal DIG-S.

Figure 5 shows a flow diagram of a method MET-1 for converting the analogue signal ANG-S into the digital signal DIG-S according to the analogue-to-digital converter system ADC-SYS-1 which is shown in Figure 3. The elements in Figure 5 that correspond to elements of Figure 2 have been designated by same reference numerals and in general are not described again for simplification. The method MET-1 contains the steps S 1, S2, S3a, S4a, S23 and S5.

The step S1 contains sub-steps S1a and S1b. The sub-step S1a splits the analogue signal ANG-S into the first part ANG-S-P1 and the second part ANG-S-P2 and the sub-step S1b filters the second part ANG-S-P2 of the analogue signal ANG-S by the filter unit FL-U for obtaining the at least one interference signal IS.

The step S3 of the method MET which is shown in Figure 2 is replaced with respect to the method MET-1 by the step S3a which contains sub-steps S3aa and S3ab. The sub-step S3aa adds the variable offset voltage signal V-OFFSET and the first reference voltage VLT-1 for obtaining the first dynamical reference voltage DYN-REF-V-1 and the sub-step S3ab adds the variable offset voltage signal V-OFFSET and the second reference voltage VLT-2 for obtaining the second dynamical voltage DYN-REF-V-2.

The step S4 of the method MET is replaced with respect to the method MET-1 by the step S4a which contains sub-steps S4aa, S4ab, S4ac and S4ad. The sub-step S4aa applies the first dynamical reference voltage DYN-REF-V-1 to the first end of the serial connection SC of resistors R-1, R-2, ..., R-N and the second dynamical voltage DYN-REF-V-2 to the second opposite end of the serial connection SC. The sub-step S4ab applies the voltage V-ANG-S which corresponds to the analogue signal ANG-S to the first inputs of the comparators CPR-1, ..., CPR-N-1. The further two sub-steps S4ac and S4ad apply the first voltage level between the first dynamical reference voltage DYN-REF-V-1 and the second dynamical reference voltage DYN-REF-V-2 to the second input of the first one of the comparators CPR-1, ..., CPR-N-1 and apply the at least second voltage between the first dynamical reference voltage level DYN-REF-V-1 and the second dynamical reference voltage DYN-REF-V-2 to the second input of the at least second one of the comparators CPR-1, ..., CPR-N-1.

Figure 6 shows schematically a block diagram of a further analogue-to-digital converter system ADC-SYS-2 for converting the analogue signal ANG-S into the digital signal DIG-S according to further embodiments. The elements in Figure 6 that correspond to elements of Figure 3 have been designated by same reference numerals and in general are not described again for simplification.

In contrast to the analogue-to-digital converter system ADC-SYS-1 shown in Figure 3, the analogue-to-digital converter system ADC-SYS-2 does not contain the second adding unit ADD-U-2 and the analogue-to-digital converter module ADC-M-1 is replaced by an analogue-to-digital converter module ADC-M-2.

The adding unit ADD-U-1 adds the variable offset voltage signal V-OFFSET and a conventional dynamical reference voltage VLT-1 a for obtaining a dynamical reference voltage DYN-REF-V-1a which is applied to a reference voltage input REFV-IN-1a of the analogue-to-digital converter module ADC-M-2. The voltage V-ANG-S which corresponds to a current voltage level of the analogue signal ANG-S is applied to a signal input ANGS-IN-b of the analogue-to-digital converter module ADC-M-2.

In conventional ADCs based on PWM or delta sigma only the conventional dynamic or constant reference voltage is applied to the reference voltage input. With respect to the analogue-to-digital converter system ADC-SYS-2 a sum voltage is applied to the reference voltage input which may exceed the conventional dynamical reference voltage level. The additional range depends on the maximum power level of a compensable interferer. If a 10 dB high interferer may be expected to cancel, the analogue-to-digital converter module ADC-M-2 needs a 10 dB larger input range than the conventional ADCs. However, the output range will be decreased and not increased. Thus, there is an increase of effective bits. In an alternative embodiment, the input power for the analogue-to-digital converter module ADC-M-2 can be simply reduced by a few dB.

The analogue-to-digital converter module ADC-M-2 is for example a conventional analogue-to-digital converter based on pulse-width modulation or based on delta-sigma modulation. An output port of the analogue-to-digital converter module ADC-M-2 provides and outputs the digital signal DIG-S.

Preferably, the filter unit FL-U of the analogue-to-digital converter system ADC-SYS-2 is a discrete device and further components of the analogue-to-digital converter system ADC-SYS-2 are integrated in a same processing chip.

The analogue-to-digital converter system ADC-SYS-2 further contains the control unit CU for controlling the filter unit FL-U such as a tunable band-pass filter by shifting the tunable band-pass filter. More details are given above with respect to the description of Figure 4.

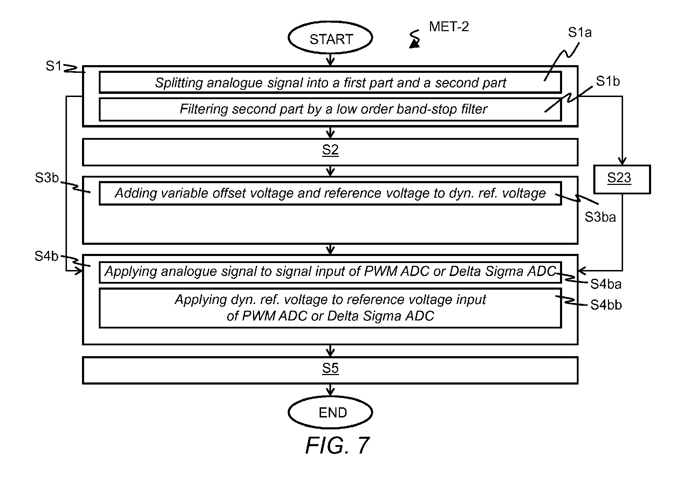

Figure 7 shows a flow diagram of a method MET-2 for converting the analogue signal ANG-S into the digital signal DIG-S according to the analogue-to-digital converter system ADC-SYS-2 which is shown in Figure 6. The elements in Figure 7 that correspond to elements of Figure 2 and Figure 5 have been designated by same reference numerals and in general are not described again for simplification. The method MET-2 contains the steps S 1, S2, S3b, S4b, S23 and S5.

The step S3 of the method MET which is shown in Figure 2 is replaced with respect to the method MET-2 by the step S3b which contains sub-step S3ba. The sub-step S3ba adds the variable offset voltage signal V-OFFSET and the reference voltage VLT-1 a for obtaining the dynamical reference voltage DYN-REF-V-1a.

The step S4 of the method MET is replaced with respect to the method MET-1 by the step S4b which contains sub-steps S4ba and S4bb. The sub-step S4ba applies the voltage V-ANG-S to the signal input ANGS-IN-b of the analogue-to-digital converter module ADC-M-2 and the sub-step S4bb applies the dynamical reference voltage DYN-REF-V-1a to the reference voltage input REFV-IN-1a of the analogue-to-digital converter module ADC-M-2.

Figure 8a shows exemplarily a simulated characteristic curve CC3 for a spectral power characteristic of an LTE signal without an application of the dynamical reference voltage. The simulation has been done with simulation program MATLAB for an ADC with a 12 bit resolution and with three sinusoid interference signals with a power that was about 40 dB larger than a power of the wanted signal WS. As shown in Figure 8a a power of a wanted LTE signal LTE-WS-1 is less than 10 dB larger than a so-called quantization noise floor due to interference signals which already cover or charge many voltage levels of the full scale limit of the ADC and therefore block these voltage levels for getting a better resolution of the wanted LTE signal LTE-WS and for a better SNR. In contrast to Figure 8a further Figure 8b shows in a further simulated characteristic curve CC4 a further spectral power characteristic of the LTE signal for the case when the dynamical reference voltage is applied. Thereby, a power of a wanted LTE signal LTE-WS-2 is almost 30 dB larger than the quantization noise floor because of a reduction of the impact of the interference signal on the full scale limit of the ADC so that a power percentage of the wanted signal WS in comparison to the entire analogue signal ANG-S is increased.

In a similar way Figure 9a shows exemplarily a simulated characteristic curve CC5 for a spectral power characteristic of a GSM signal as an interference signal GSM-IS1 and an LTE signal as a wanted signal LTE-WS1 without an application of the dynamical reference voltage and Figure 9b shows a further simulated characteristic curve CC6 for a further spectral power characteristic of the GSM signal as an interference signal GSM-IS2 and then LTE signal as a wanted signal LTE-WS2 when the dynamical reference voltage is applied. A usage of the dynamical reference voltage increases a power ratio over 20 dB between the wanted signal LTE-WS1 and the wanted signal LTE-WS.

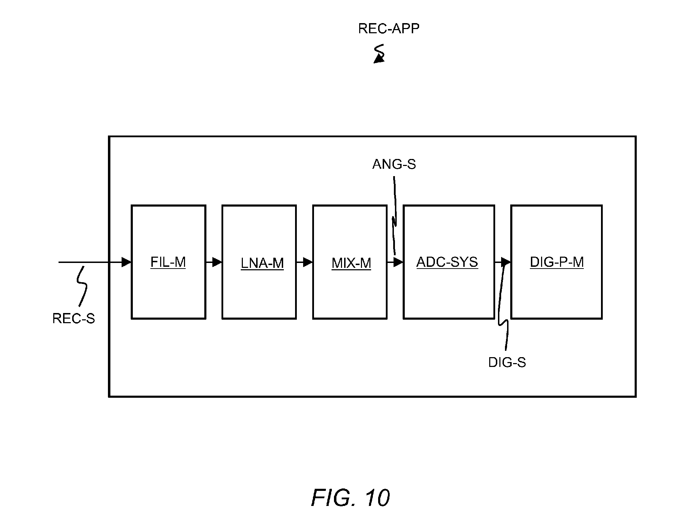

Figure 10 shows schematically a block diagram of a receiver apparatus REC-APP which contains an analogue-to-digital converter system ADC-SYS for converting the analogue signal ANG-S into the digital signal DIG-S according to an exemplary embodiment. The analogue-to-digital converter system ADC-SYS may be for example the analogue-to-digital converter system ADC-SYS-1 which is shown in Figure 3 or the analogue-to-digital converter system ADC-SYS-2 which is shown in Figure 4. The receiver apparatus REC-APP receives a band limited radio frequency signal REC-S and uses analogue and digital processing to extract the information modulated by the received radio frequency signal REC-S. Therefore, the received radio frequency signal REC-S may be equalized, demodulated, filtered, amplified and transformed digitally. For these processing steps, the receiver apparatus REC-APP further contains a filter module FIL-M, a low noise amplifier module LNA-M, an optional mixer module MIX-M, further optional IF filters and a digital processing module DIG-P-M.

The received radio frequency signal REC-S is provided for example from an antenna system to an input of the receiver apparatus REC-APP and is further provided to the filter module FIL-M which may be for example a bandpass filter. A signal band of interest is filtered out by the band pass filter and subsequently fed to the low noise amplifier module LNA-M. Afterwards, the signal may be provided to the mixer module MIX-M for down conversion and then to the analogue-to-digital converter system ADC-SYS. Depending on a concrete application, the analogue-to-digital converter system ADC-SYS may directly digitize a radio frequency signal without using the mixer module MIX-M for down conversion. The digital signal DIG-S from the analogue-to-digital converter system ADC-SYS is further provided to the digital processing module DIG-P-Me for further digital signal processing.

The receiver apparatus REC-APP is for example a receiver apparatus for radio frequency signals or for frequency limited signals such as IF signals (IF = Intermediate Frequency).

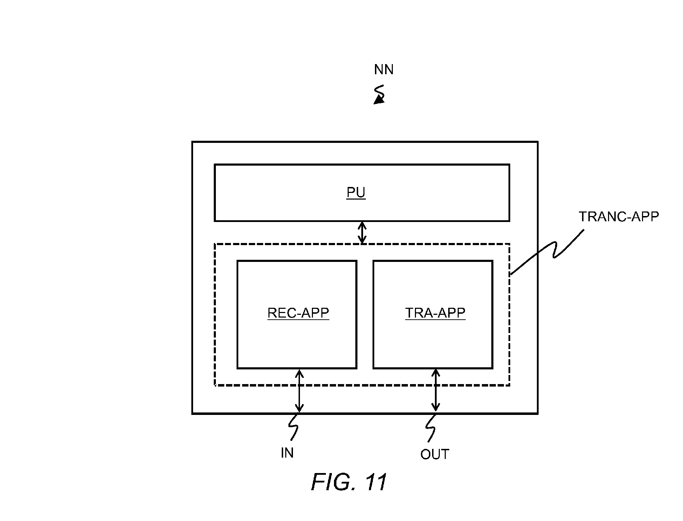

Figure 11 shows schematically a block diagram of a network node NN which contains the receiver apparatus REC-APP with the analogue-to-digital converter system ADC-SYS for converting the analogue signal ANG-S into the digital signal DIG-S according to an exemplary embodiment.

The network node NN contains a transceiver apparatus TRANC-APP and a processing unit PU which controls the transceiver apparatus TRANC-APP. The transceiver apparatus TRANC-APP contains the receiver apparatus REC-APP as shown in Figure 10 and a transmitter apparatus TRA-APP. The network node NN further contains an input interface IN which is connected to the receiver apparatus REC-APP and an output interface OUT which is connected to the transmitter apparatus TRA-APP.

The network node NN is for example a base station, a relay, a repeater or a mobile station.

The term "base station" may be considered synonymous to and/or referred to as a base transceiver station, access point base station, access point, macro base station, macrocell, micro base station, microcell, femtocell, picocell etc. and may describe equipment that provides wireless connectivity via one or more radio links to one or more mobile stations. The base station BS1-1 may be for example an LTE Node B, an IEEE 802.11 access point, a WiMAX base station etc.

The term "macro base station" may be considered synonymous to and/or referred to a base station, which provides a radio cell having a size in a range of several hundred meters up to several kilometres. A macro base station usually has a maximum output power of typically tens of watts.

The term "micro base station" may be considered synonymous to and/or referred to a base station, which provides a radio cell having a size in a range of several tens of meters up to hundred meters. A micro base station usually has a maximum output power of typically several watts.

The term "macro cell" may be considered synonymous to and/or referred to a radio cell, which provides the widest range of all radio cell sizes. Macro cells are usually found in rural areas or along highways.

The term "micro cell" may be considered synonymous to and/or referred to a radio cell in a cellular network served by a low power cellular base station, covering a limited area (smaller than an area of a macro cell) such as a mall, a hotel, or a transportation hub. A microcell is referred to a group of radio cells, which contain pico cells and femto cells.

The term "pico cell" may be considered synonymous to and/or referred to a small cellular base station typically covering a small area, such as in-building (offices, shopping malls, train stations, stock exchanges, etc.), or more recently in-aircraft. In cellular networks, pico cells are typically used to extend coverage to indoor areas where outdoor signals do not reach well, or to add network capacity in areas with very dense phone usage, such as train stations.

The term "femto cell" may be considered synonymous to and/or referred to a small, low-power cellular base station, typically designed for use in a home or small business. A broader term which is more widespread in the industry is small cell, with femto cell as a subset.

The term "repeater" may be considered synonymous to and/or referred to as an electronic device that receives a signal and simply retransmits it at a higher level or higher power, or onto another side of an obstruction, so that the signal can cover longer distances.

The term "relay" may be considered synonymous to and/or referred to as an electronic radio communication device that receives a signal and retransmits a different signal not only at a higher level or higher power, but also at a different frequency and/or different time slot and/or spreading code, to increase capacity in a wireless access network and to improve wireless link performance.

The term "mobile station" may be considered synonymous to, and may hereafter be occasionally referred to, as a mobile unit, mobile user, access terminal, user equipment, subscriber, user, remote station or a small cell, pico cell or femto cell when located in a moving vehicle such as a bus, a train or even a car. Each of the mobile stations UE1, UE2 may be for example a cellular telephone, a smart phone, a portable computer, a pocket computer, a hand-held computer, a personal digital assistant, a moving base station, a smart watch, a head mounted display such as a Google glass or a car-mounted mobile device such as a repeater or relay.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for performing a certain function" shall be understood as functional blocks comprising circuitry that is adapted for performing the certain function, respectively. Hence, a "means for something" may as well be understood as a "means being adapted or suited for something". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, DSP hardware, network processor, ASIC, FPGA, read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the detailed description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that the methods MET, MET-11, MET-2 disclosed in the specification or in the claims may be implemented by a device having means for performing each of the respective steps of these methods. Preferably, a computer program product may contain computer-executable instructions for performing the methods MET, MET-11, MET-2, when the computer program product is executed on a programmable hardware device such as a DSP, an ASIC or an FPGA. Preferably, a digital data storage device may encode a machine-executable program of instructions to perform one of the methods MET, MET-11, MET-2.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. A method (MET, MET-1, MET-2) for converting an analogue signal (ANG-S) into a digital signal (DIG-S) comprising:
- extracting (S 1) at an input of an analogue-to-digital converter system (ADC-SYS-1, ADC-SYS-2) at least one interference signal (IS) from said analogue signal (ANG-S) comprising a wanted signal (WS) and said at least one interference signal (IS),
- generating (S2) from said at least one interference signal (IS) a variable offset voltage signal (V-OFFSET),
- determining (S3, S3a, S3b) at least one dynamical reference voltage (DYN-REF-V-1, DYN-REF-V-2, DYN-REF-V-1a) based on said variable offset voltage signal (V-OFFSET),
- applying (S4) said at least one dynamical reference voltage (DYN-REF-V-1, DYN-REF-V-2, DYN-REF-V-1a) to at least one reference voltage input (REFV-IN-1, REFV-IN-2, REFV-IN-1a) of an analogue-to-digital converter module (ADC-M-1, ADC-M-2) and further applying (S4) said analogue signal (V-ANG-S) to a signal input (ANGS-IN-a, ANGS-IN-b) of said analogue-to-digital converter module (ADC-M-1, ADC-M-2), and
- converting (S5) said analogue signal (V-ANG-S) into said digital signal (DIG-S) based on said at least one dynamical reference voltage (DYN-REF-V-1, DYN-REF-V-2, DYN-REF-V-1a).

2. Method (MET, MET-1, MET-2) according to claim 1, wherein said method (MET, MET-1, MET-2) further comprises delaying (S23) said analogue signal (ANG-S-P1) for compensating a time delay based on said extracting (S1) of said at least one interference signal (IS) and based on said generating (S2) of said variable offset voltage signal (V-OFFSET).

3. Method (MET, MET-1, MET-2) according to any of the preceding claims, wherein said extracting (S1) comprises splitting (S1a) said analogue signal (ANG-S) into a first part (ANG-S-P1) to be applied to said analogue-to-digital converter module (ADC-M-1, ADC-M-2) and a second part (ANG-S-P2) for said generating (S2) of said variable offset voltage signal (V-OFFSET).

4. Method (MET, MET-1, MET-2) according to claim 3, wherein said splitting (S1a) splits said analogue signal (ANG-S) by a predefined power level ratio of 1 to 1 between a power level of said first part (ANG-S-P1) and a power level of said second part (ANG-S-P2).

5. Method (MET, MET-1, MET-2) according to any of the preceding claims, wherein said extracting (S1) comprises filtering (S1b) said analogue signal (ANG-S) by a band pass filter (FL-U) for obtaining said at least one interference signal (IS).

6. Method (MET, MET-1, MET-2) according to any of the preceding claims 1 to 4, wherein said extracting (S 1) comprises filtering (S1b) said analogue signal (ANG-S) by a band stop filter (FL-U) for obtaining said at least one interference signal (IS).

7. Method (MET, MET-1, MET-2) according to any of the preceding claims, wherein said extracting (S1) extracts one of said at least one interference signal (IS) with a maximum power level.

8. Method (MET-1) according to any of the preceding claims, wherein said determining (S3a) comprises adding (S3aa) said variable offset voltage and a first reference voltage to a first dynamical reference voltage (DYN-REF-V-1) and further adding (S3ab) said variable offset voltage and a second reference voltage larger than said first reference voltage to a second dynamical voltage (DYN-REF-V-2) and wherein said applying (S4a) comprises applying (S4aa) said first dynamical reference voltage (DYN-REF-V-1) to a first end of a serial connection (SC) of resistors (R-1, R-2, ..., R-N) and said second dynamical voltage (DYN-REF-V-2) to a second opposite end of said serial connection (SC), applying (S4ab) said analogue signal (V-ANG-S) to first inputs of a group of comparators (CPR-1, ..., CPR-N-1), applying (S4ac) a first voltage level between said first dynamical reference voltage (DYN-REF-V-1) and said second dynamical reference voltage (DYN-REF-V-2) to a second input of a first one of said group of comparators (CPR-1, ..., CPR-N-1), and applying (S4ad) at least a second voltage between said first dynamical reference voltage level (DYN-REF-V-1) and said second dynamical reference voltage (DYN-REF-V-2) and different to said first voltage level to a second input of a second one of said group of comparators (CPR-1, ..., CPR-N-1).

9. Method (MET-2) according to any of the preceding claims 1 to 7, wherein said determining (S3b) comprises adding (S3ba) said variable offset voltage and a reference voltage to a dynamical reference voltage (DYN-REF-V-1a), wherein said applying (S4b) comprises applying (S4ba) said analogue signal (V-ANG-S) to a signal input (ANGS-IN-b) of said analogue-to-digital converter module (ADC-M-2) and applying said dynamical reference voltage (DYN-REF-V-1 a) to a reference voltage input (REFV-IN-1a) of said analogue-to-digital converter module (ADC-M-2).

10. An analogue-to-digital converter system (ADC-SYS-1, ADC-SYS-2) for converting an analogue signal (ANG-S) into a digital signal (DIG-S) comprising:
- means (EXT-U, FL-U) for extracting at an input of said analogue-to-digital converter system (ADC-SYS-1, ADC-SYS-2) at least one interference signal (IS) from said analogue signal (ANG-S) comprising a wanted signal (WS) and said at least one interference signal (IS),
- means (GC-2) for generating from said at least one interference signal (IS) a variable offset voltage signal (V-OFFSET),
- means (ADD-U-1, ADD-U-2) for determining at least one dynamical reference voltage (DYN-REF-V-1, DYN-REF-V-2, DYN-REF-V-1 a) based on said variable offset voltage signal (V-OFFSET),
- means (REFV-IN-1, REFV-IN-2, REFV-IN-1a, ANGS-IN-a, ANGS-IN-b) for applying said at least one dynamical reference voltage (DYN-REF-V-1, DYN-REF-V-2, DYN-REF-V-1a) to at least one reference voltage input (REFV-IN-1, REFV-IN-2, REFV-IN-1a) of an analogue-to-digital converter module (ADC-M-1, ADC-M-2) and further applying (S4) said analogue signal (V-ANG-S) to a signal input (ANGS-IN-a, ANGS-IN-b) of said analogue-to-digital converter module (ADC-M-1, ADC-M-2), and
- means (ADC-M-1, ADC-M-2) for converting said analogue signal (V-ANG-S) into said digital signal (DIG-S) based on said at least one dynamical reference voltage (DYN-REF-V-1, DYN-REF-V-2, DYN-REF-V-1a).

11. Analogue-to-digital converter system (ADC-SYS-1, ADC-SYS-2) according to claim 10, wherein said analogue-to-digital converter system (ADC-SYS-1, ADC-SYS-2) is based on a Flash analogue-to-digital converter, an analogue-to-digital converter with pulse-width modulation or an analogue-to-digital converter with delta-sigma modulation.

12. A receiver apparatus (REC-APP) comprising an analogue-to-digital converter system (ADC-SYS) according to claim 11 or claim 12.

13. Receiver apparatus (REC-APP) according to claim 12, wherein said receiver apparatus (REC-APP) is a receiver apparatus for radio frequency signals.

14. A network node (NN) comprising a receiver apparatus (REC-APP) according to claim 12 or claim 13.

15. Network node (NN) according to claim 14, wherein said network node (NN) is a base station, a relay, a repeater or a mobile station.

## Amended claims

### Amended claims in accordance with Rule 137(2) EPC.

1. A method (MET, MET-1, MET-2) for converting an analogue signal (ANG-S) into a digital signal (DIGS) comprising:
- extracting (S1) at an input of an analogue-to-digital converter system (ADC-SYS-1, ADC-SYS-2) at least one interference signal (IS) from said analogue signal (ANG-S) comprising a wanted signal (WS) and said at least one interference signal (IS),
- generating (S2) from said at least one interference signal (IS) a variable offset voltage signal (V-OFFSET),
- determining (S3, S3a, S3b) at least one dynamical reference voltage (DYN-REF-V-1, DYN-REF-V-2, DYN-REF-V-1a) based on said variable offset voltage signal (V-OFFSET),
- applying (S4) said at least one dynamical reference voltage (DYN-REF-V-1, DYN-REF-V-2, DYN-REF-V-1a) to at least one reference voltage input (REFV-IN-1, REFV-IN-2, REFV-IN-1a) of an analogue-to-digital converter module (ADC-M-1, ADC-M-2) and further applying (S4) said analogue signal (V-ANG-S) to a signal input (ANGS-IN-a, ANGS-IN-b) of said analogue-to-digital converter module (ADC-M-1, ADC-M-2), and
- converting (S5) said analogue signal (V-ANG-S) into said digital signal (DIG-S) based on said at least one dynamical reference voltage (DYN-REF-V-1, DYN-REF-V-2, DYN-REF-V-1a).

2. Method (MET, MET-1, MET-2) according to claim 1, wherein said method (MET, MET-1, MET-2) further comprises delaying (S23) said analogue signal (ANG-S-P1) for compensating a time delay based on said extracting (S1) of said at least one interference signal (IS) and based on said generating (S2) of said variable offset voltage signal (V-OFFSET).

3. Method (MET, MET-1, MET-2) according to any of the preceding claims, wherein said extracting (S1) comprises splitting (S1a) said analogue signal (ANG-S) into a first part (ANG-S-P1) to be applied to said analogue-to-digital converter module (ADC-M-1, ADC-M-2) and a second part (ANG-S-P2) for said generating (S2) of said variable offset voltage signal (V-OFFSET).

4. Method (MET, MET-1, MET-2) according to claim 3, wherein said splitting (S1a) splits said analogue signal (ANG-S) by a predefined power level ratio of 1 to 1 between a power level of said first part (ANG-S-P1) and a power level of said second part (ANG-S-P2).

5. Method (MET, MET-1, MET-2) according to any of the preceding claims, wherein said extracting (S1) comprises filtering (S1b) said analogue signal (ANG-S) by a band pass filter (FL-U) for obtaining said at least one interference signal (IS).

6. Method (MET, MET-1, MET-2) according to any of the preceding claims 1 to 4, wherein said extracting (S1) comprises filtering (S1b) said analogue signal (ANG-S) by a band stop filter (FL-U) for obtaining said at least one interference signal (IS).

7. Method (MET, MET-1, MET-2) according to any of the preceding claims, wherein said extracting (S1) extracts one of said at least one interference signal (IS) with a maximum power level.

8. Method (MET-1) according to any of the preceding claims, wherein said determining (S3a) comprises adding (S3aa) said variable offset voltage and a first reference voltage to a first dynamical reference voltage (DYN-REF-V-1) and further adding (S3ab) said variable offset voltage and a second reference voltage larger than said first reference voltage to a second dynamical voltage (DYN-REF-V-2) and wherein said applying (S4a) comprises applying (S4aa) said first dynamical reference voltage (DYN-REF-V-1) to a first end of a serial connection (SC) of resistors (R-1, R-2, ..., R-N) and said second dynamical voltage (DYN-REF-V-2) to a second opposite end of said serial connection (SC), applying (S4ab) said analogue signal (V-ANG-S) to first inputs of a group of comparators (CPR-1, ..., CPR-N-1), applying (S4ac) a first voltage level between said first dynamical reference voltage (DYN-REF-V-1) and said second dynamical reference voltage (DYN-REF-V-2) to a second input of a first one of said group of comparators (CPR-1, ..., CPR-N-1), and applying (S4ad) at least a second voltage between said first dynamical reference voltage level (DYN-REF-V-1) and said second dynamical reference voltage (DYN-REF-V-2) and different to said first voltage level to a second input of a second one of said group of comparators (CPR-1, ..., CPR-N-1).

9. Method (MET-2) according to any of the preceding claims 1 to 7, wherein said determining (S3b) comprises adding (S3ba) said variable offset voltage and a reference voltage to a dynamical reference voltage (DYN-REF-V-1a), wherein said applying (S4b) comprises applying (S4ba) said analogue signal (V-ANG-S) to a signal input (ANGS-IN-b) of said analogue-to-digital converter module (ADC-M-2) and applying said dynamical reference voltage (DYN-REF-V-1a) to a reference voltage input (REFV-IN-1a) of said analogue-to-digital converter module (ADC-M-2).

10. An analogue-to-digital converter system (ADC-SYS-1, ADC-SYS-2) for converting an analogue signal (ANG-S) into a digital signal (DIG-S) comprising:
- means (EXT-U, FL-U) for extracting at an input of said analogue-to-digital converter system (ADC-SYS-1, ADC-SYS-2) at least one interference signal (IS) from said analogue signal (ANG-S) comprising a wanted signal (WS) and said at least one interference signal (IS),
- means (GC-2) for generating from said at least one interference signal (IS) a variable offset voltage signal (V-OFFSET),
- means (ADD-U-1, ADD-U-2) for determining at least one dynamical reference voltage (DYN-REF-V-1, DYN-REF-V-2, DYN-REF-V-1a) based on said variable offset voltage signal (V-OFFSET),
- means (REFV-IN-1, REFV-IN-2, REFV-IN-1a, ANGS-IN-a, ANGS-IN-b) for applying said at least one dynamical reference voltage (DYN-REF-V-1, DYN-REF-V-2, DYN-REF-V-1a) to at least one reference voltage input (REFV-IN-1, REFV-IN-2, REFV-IN-1a) of an analogue-to-digital converter module (ADC-M-1, ADC-M-2) and further applying (S4) said analogue signal (V-ANG-S) to a signal input (ANGS-IN-a, ANGS-IN-b) of said analogue-to-digital converter module (ADC-M-1, ADC-M-2), and
- means (ADC-M-1, ADC-M-2) for converting said analogue signal (V-ANG-S) into said digital signal (DIG-S) based on said at least one dynamical reference voltage (DYN-REF-V-1, DYN-REF-V-2, DYN-REF-V-1a).

11. Analogue-to-digital converter system (ADC-SYS-1, ADC-SYS-2) according to claim 10, wherein said analogue-to-digital converter system (ADC-SYS-1, ADC-SYS-2) is based on a Flash analogue-to-digital converter, an analogue-to-digital converter with pulse-width modulation or an analogue-to-digital converter with delta-sigma modulation.

12. A receiver apparatus (REC-APP) comprising an analogue-to-digital converter system (ADC-SYS) according to claim 10 or claim 11.

13. Receiver apparatus (REC-APP) according to claim 12, wherein said receiver apparatus (REC-APP) is a receiver apparatus for radio frequency signals.

14. A network node (NN) comprising a receiver apparatus (REC-APP) according to claim 12 or claim 13.

15. Network node (NN) according to claim 14, wherein said network node (NN) is a base station, a relay, a repeater or a mobile station.
